# EUROPÄISCHE PATENTSCHRIFT

(11) **EP 2 711 488 B1**
(45) Veröffentlichungstag und Bekanntmachung des Hinweises auf die Patenterteilung: **21.11.2018**
(21) Anmeldenummer: 13184271.8
(22) Anmeldetag: 13.09.2013
(51) Int. Cl.: E05B 81/78, H03K 17/955

(54) **KRAFTFAHRZEUGTÜRGRIFF MIT SENSORELEKTRONIK**
MOTOR VEHICLE DOOR HANDLE WITH SENSOR ELECTRONICS
POIGNÉE DE PORTIÈRE DE VÉHICULE AUTOMOBILE À ÉLECTRONIQUE DE CAPTEUR

(30) Priorität: 25.09.2012 DE 102012109034
(43) Veröffentlichungstag der Anmeldung: 26.03.2014
(73) Patentinhaber: Huf Hülsbeck & Fürst GmbH & Co. KG, 42551 Velbert (DE)
(72) Erfinder: Peschl, Andreas, 42555 Velbert (DE)
(74) Vertreter: Zenz Patentanwälte Partnerschaft mbB

(56) Entgegenhaltungen:
- EP-A2- 1 840 845
- WO-A1-2012/048770
- WO-A1-2013/057159
- WO-A2-2012/175580
- US-A1- 2003 107 473

## Beschreibung

Die Erfindung betrifft einen Türgriff für ein Kraftfahrzeug mit einer darin angeordneten Sensorelektronik. Insbesondere betrifft die Erfindung einen Türgriff mit einer kapazitiven Sensorelektronik sowie einer Sensorauswerte- und Steuerschaltung, die auf einer Leiterplatte angeordnet ist. Mit der Sensorauswerte- und Steuerschaltung ist eine Sensorelektrode eines kapazitiven Sensors verbunden. Der kapazitive Sensor erfasst eine Annäherung eines Objekts, beispielsweise eines Bedienerkörperteils, an einen Türgriff. Die Leiterplatte und die Sensorelektrode sind im Inneren des Türgriffes angeordnet und die Leiterplatte ist als mehrlagige Leiterplatte ausgebildet.

Ein Türgriff der genannten Art ist beispielsweise in der Anmeldung EP 1 840 845 A2 offenbart.

Ein weiterer Türgriff mit ähnlichem Aufbau ist der DE 102 009 002 566 A1 zu entnehmen.

Sensorelektronik für Türgriffe der genannten Art werden verwendet, um die Annäherung einer Hand eines Bedieners an einen Türgriffs des Fahrzeuges zu erfassen. Wird die Annäherung der Hand des Bedieners detektiert, wird eine im Kraftfahrzeug angeordnete Steuerelektronik angesteuert, um eine Funkabfrage eines von dem Bediener mitgeführten ID-Gebers (elektronischen Schlüssels) zur veranlassen. Eine solche Abfrage wird beispielsweise im Niederfrequenzbereich von einer Antenne im Türgriff gestartet, wobei eine anschließende Autorisierungskommunikation zwischen Fahrzeugsteuereinrichtung und Fahrzeugschlüssel in einem Hochfrequenzbereich abläuft.

Zum Erfassen der Annäherung eines Körperteils des Bedieners an dem Türgriff wird dazu ein kapazitiver Annäherungssensor verwendet. Kapazitive Annäherungssensoren sind in der Technik bekannt, beispielsweise sind sie in der Druckschrift EP 1 339 025 A1 oder auch der Druckschrift EP 1235 190 beschrieben. Das Grundprinzip eines kapazitiven Sensors ist auch in der Druckschrift US 5,730,165 beschrieben, auf die hier zum Verständnis der Wirkungsweise eines kapazitiven Sensors verwiesen wird.

Die WO 2012/175580 A2 beschreibt einen kapazitiven Sensor mit mehreren, übereinander angeordneten Elektrodenlagen, wobei der Sensor zur Erfassung der Annäherung einer Hand an ein elektronisches Gerät ausgebildet ist.

Es ist auch bekannt, zur Verbesserung der Empfindlichkeit einer kapazitiven Sensorelektrode auf der dem Erfassungsbereich abgewandten Seite der Sensorelektrode eine Schirmelektrode anzuordnen, welche zum Beispiel bezüglich des elektrischen Potentials der Sensorelektrode nachgeführt wird (siehe DE 102 009 002 566).

Die Sensorelektroden der genannten Art sind vornehmlich möglichst großflächige Sensorelektroden, die in ihrem Erfassungsbereich nach außen von einem Kraftfahrzeug weggerichtet sind oder den Innenraum des Griffes, also den Bereich zwischen Griffhandhabe und Fahrzeugblech überwachen. Die Feldlinien eines entsprechenden Elektrodenaufbaus durchgreifen diesen Raum und detektierten die in den Bereich bewegte Hand eines Benutzers oder ein sonstiges Objekt.

Kraftfahrzeugtürgriffe weisen zusätzlich zu der Detektion in dieser Weise jedoch auch weitere Detektionsbereiche auf, zum Beispiel Taster oder Sensoren für eine weitere Fahrzeugfunktion, insbesondere eine Auslösung eines Vorgangs zum Verschließen des Fahrzeuges bei Betätigung einer Taste oder Sensorfläche. Dazu können weitere Sensorelektroden mit derselben oder einer weiteren Steuerschaltung und Platine gekoppelt sein.

Es ist beispielsweise bekannt, ein Elektrodenblech gewinkelt an eine Platine anzuordnen und mit einer Steuerschaltung zu koppeln. Auf der Platine selbst ist dann die primäre Sensorelektrode mit großer Erfassungsfläche in der Platinenebene angeordnet und das gewinkelte oder abgekantete Blech stellt eine Elektrodenfläche dar, die sich in einem Winkel zu der Platinenebene erstreckt. Das gewinkelte Blech ist insbesondere am Randbereich der Platine angeordnet und zum Beispiel in einem rechten Winkel von der Platine weggeführt. Bei einer derartigen Anordnung wird durch die große Elektrodenfläche auf der Platinenebene selbst ein Bereich vor dem Griff, senkrecht zur Elektrodenebene überwacht und das kleinere, gewinkelte Blech ist als separate kapazitive Sensorelektrode zur Überwachung eines kleineren Erfassungsbereiches oberhalb des gewinkelten Blechabschnitts ausgerichtet. Beispielsweise kann ein Finger auf einen Endabschnitt des Türgriffes gelegt werden, um von dem abgewinkelten Elektrodenblech detektiert zu werden. Die unterschiedliche Ausrichtung der Sensorelektroden ermöglicht dabei eine fehlerfreie Differenzierung zwischen den beiden Betätigungsrichtungen.

Eine derartige Gestaltung einer Sensorelektrodenanordnung mit zusätzlicher Elektrodenfläche ist aufwändig und in der Herstellung zeitintensiv.

Aufgabe der Erfindung ist es daher, eine Sensorelektrodenanordnung zu schaffen, die eine Überwachung auch in einem Bereich senkrecht zu einer Leiterplatte oder Platine erlaubt.

Diese Aufgabe wird erfindungsgemäß gelöst durch eine Sensoranordnung mit den Merkmalen des Patentanspruches 1.

Gemäß der erfindungsgemäßen Lösung weist der Kraftfahrzeugtürgriff eine Sensorelektrode eines ersten kapazitiven Sensors, welche zum Erfassen einer Annäherung eines Objekts und zum Auslösen eines Betätigungsvorgangs dient. Wenn ein Bedienerkörperteil, zum Beispiel eine Hand oder ein Finger, sich der Elektrode nähert, wird diese Annäherung gemäß der oben erläuterten kapazitiven Erfassung registriert und die Steuerschaltung steuert eine entsprechende Fahrzeugfunktion an.

In dem erfindungsgemäßen Kraftfahrzeugtürgriff ist im Griff, insbesondere in der zu umgreifenden Handhabe eine Leiterplatte angeordnet, welche elektrische Bauteile auf ihrer Leiterplattenfläche aufnimmt und auch die Sensorelektrode trägt. Mit der Sensorelektrode ist die genannte Auswerteschaltung gekoppelt, um Sensorelektrodensignale abzunehmen oder auch Signale zur Auswertung der Sensorelektrode an diese anzulegen, zum Beispiel um Lade- oder Entladevorgänge der Sensorelektrode herbeizuführen.

Für die Leiterplatte in dem Türgriff wird eine mehrlagige Leiterplatte verwendet und die Sensorelektrode wird erfindungsgemäß durch eine Mehrzahl von Leiterstrukturen gebildet, die in verschiedenen, insbesondere benachbarten Leiterplattenebenen ausgebildet sind und mittels Durchkontaktierungen (Vias) elektrisch gekoppelt sind. Mehrere Leiterstrukturen in den verschiedenen Ebenen wirken also mit den Durchkontaktierungen zusammen, um eine netzartige Leiteranordnung zu bilden, die in einer Ebene liegt, welche durch einige oder sämtliche Leiterplattenebenen geht. Die Sensorelektrode wird also nicht flächig auf eine Leiterplattenebene ausgebildet, stattdessen werden nebeneinander, auf mehreren Ebenen Leiterabschnitte ausgebildet. Dieses Leiternetz erstreckt sich in einer senkrechten oder schrägen Ebene zu der primären Leiterplattenfläche, also derjenigen Fläche, auf welcher die Schaltelemente und Leiterbahnen angeordnet sind.

Anders ausgedrückt, es wird durch die Leiterstrukturen in den verschiedenen Leiterebenen und die Vias eine Netzelektrode gebildet, die in Richtung der Schmalseite einer Leiterplatte orientiert ist und sich im Inneren der Leiterplatte erstreckt oder im unmittelbaren Randbereich der Leiterplatte.

Die Verwendung und Ausbildung mehrlagiger Leiterplatten ist in der Technik bekannt und üblich. Erfindungswesentlich ist, diese Mehrlagigkeit zu nutzen, um durch nebeneinander angeordnete und durchkontaktierte Strukturen eine kapazitive Sensorelektrode mit einer Erfassungsrichtung zu bilden, die schräg oder senkrecht zu der primären Sensorelektrode orientiert ist, wenn die primäre Sensorelektrode auf der äußeren Flachseite oder Leiterplattenfläche angeordnet oder aufgebracht ist.

Die Leiterstrukturen in den benachbarten Leiterplattenebenen brauchen nicht völlig identisch ausgebildet zu sein, außerdem muss auch nicht jeder der Leitplattenebenen mit einer entsprechenden Leiterstruktur versehen sein. Unter benachbart ist in diesem Zusammenhang also zu verstehen, dass es sich um Ebenen derselben Leiterplatte handelt, wobei auch zwischenliegende Ebenen ohne entsprechende Beteiligung an der Elektrodenausbildung vorhanden sein können.

Die Leiterstrukturen können als Streifen, Bögen oder sonstige Strukturen ausgebildet sein. Es ist außerdem auch möglich, an verschiedenen Bereichen der Leiterplatte entsprechende Elektrodenanordnungen auszubilden.

Es ist besonders vorteilhaft, wenn die Netzelektrode im Randbereich der Sensorelektrode ausgebildet ist. Eine entsprechende Anordnung verbessert die Erfassungsgenauigkeit und die Orientierung der Sensorelektrode.

Begrenzendes Kriterium hierbei wird sein, wie nah die Durchkontaktierungen (Vias) am Rand der Leiterplatte ausgebildet sein können ohne den Ausschuss der Leiterplatten bei der Herstellung signifikant zu erhöhen.

Die Ausbildung der Durchkontaktierungen kann beliebig sein, insbesondere können herkömmliche Vias mit leitender Innenbeschichtung verwendet werden, um die Leiterstrukturen auf den mehreren Lagen zu verbinden.

Die Kontaktierung dieser Elektrodennetzanordnung durch die Ansteuerschaltung oder die Auswerteschaltung findet in einer oder mehreren der Ebenen statt, beispielsweise auf der äußeren Oberfläche der Leiterplatte.

In einer bevorzugten Weiterbildung der Erfindung sind mehrere derartige Netzelektroden versetzt zueinander angeordnet und separat kontaktiert, um die vorstehend genannte Sensorelektrode mit dahinterliegender Shield-Elektrode auszubilden. Die Shield-Elektrode kann mit gleichen Abmessungen oder anderen Abmessungen sowie mit Versatz in beliebiger Richtung gebildet sein. Auch eine Masseelektrode kann auf diese Weise als Netzelektrode ausgebildet werden, wobei dann alle dieser Elektroden, also die Sensorelektrode, die Shield-Elektrode und die Masseelektrode innerhalb der Leiterplatte ausgebildet sind.

Die gesamten Konzepte der Ansteuerung und Auswertung von kapazitiven Sensorelektroden, die im Stand der Technik bereits für herkömmliche Elektrodenanordnungen herangezogen werden, können auf diese netzartigen Elektroden übertragen werden. Die Erfindung wird nun anhand eines Ausführungsbeispiels näher erläutert.
Figur 1A zeigt eine Aufsicht auf einen stilisierten Türgriff mit einer erfindungsgemäßen Sensoranordnung;
Figur 1B zeigt den Türgriff aus Figur 1A in einer Frontansicht;
Figur 1C zeigt den Türgriff aus den Figuren 1A und 1B in einer perspektivischen Ansicht;
Figur 2A zeigt eine schematische Ansicht einer erfindungsgemäßen Sensoranordnung;
Figur 2B zeigt eine teildurchlässige Ansicht der Sensoranordnung aus Figur 2A;
Figur 2C zeigt die Sensoranordnung aus den Figuren 2A und 2B in einer Frontansicht;
Figur 3A zeigt einen vergrößerten Teilabschnitt mit entfernten Komponenten aus der Figur 2A;
Figur 3B zeigt die Anordnung aus Figur 3A in einer teildurchlässigen Ansicht.

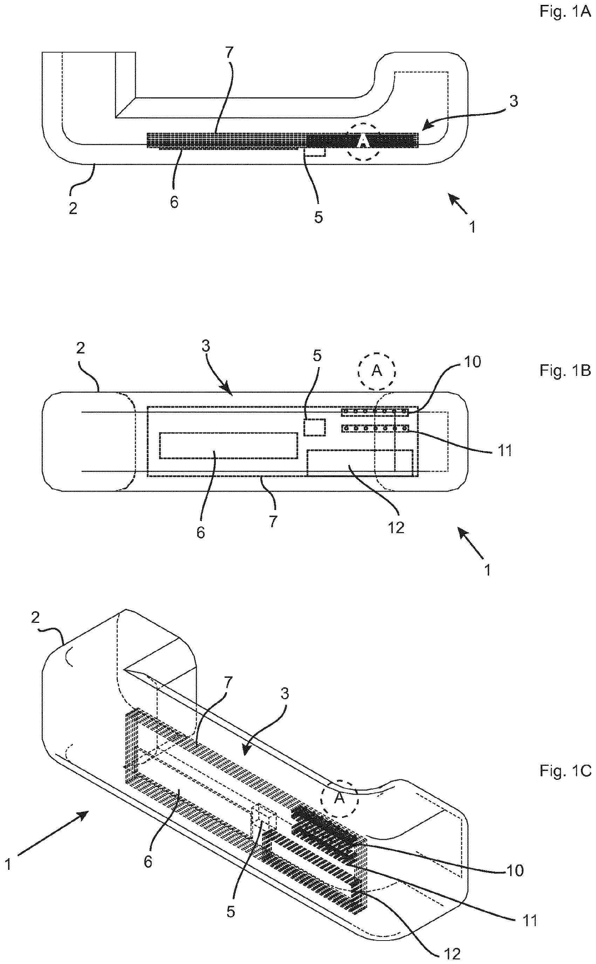

In den Figuren 1A, 1B und 1C ist ein Türgriff 1 gezeigt, der eine Handhabe 2 aufweist. Die Handhabe ist als Halteelement zur Betätigung und Öffnung einer Tür ausgebildet und kann mit mechanischen Komponenten eines Türschlosses zur Betätigung gekoppelt sein. Derartige Komponenten sind im Rahmen dieser Beschreibung nicht bezeichnet, da sie für die Erfindung nicht wesentlich sind.

In der Handhabe 2 ist eine Sensoranordnung 3 angeordnet. Die Sensoranordnung umfasst verschiedene Komponenten, um eine Annäherung an den Türgriff zu detektieren. Insbesondere weist die Sensoranordnung Elektronikkomponenten 5 auf, die auf einer Mehrschicht-Leiterplatte 7 angeordnet sind. Die Mehrschicht-Leiterplatte 7 ist zur Verdeutlichung der Erfindung hier mit größerer Dicke in senkrechter Richtung zu ihrer Leiterplattenebene dargestellt, um die Erfindung klarer verständlich zu machen. Auf der Leiterplattenoberfläche ist eine flächige Elektrode 6 angeordnet, welche als kapazitive Sensorelektrode wirkt. Annäherung an den Türgriff können über eine Kapazitätsänderung der Elektrode 6 detektiert werden. Die dazu erforderlichen Komponenten sind hier lediglich stilisiert durch die Elektronikkomponenten 5 dargestellt, ebenso wie Leiterbahnen auf der Platine nicht gezeigt sind, da dies das Verständnis der Erfindung erschweren würde.

Die Ansteuerung und Auswertung der Detektionseinrichtung bezüglich der Sensorelektrode 6 erfolgt in herkömmlicher Weise und wird hier nicht näher beschrieben, insbesondere können zur Kapazitätsbestimmung Lade-Entladezyklen vorgenommen und vermessen werden. Gemäß der Erfindung sind jedoch bei der Sensoreinrichtung 3 in mehreren benachbarten Lagen der Leiterplatte 7 Leitstrukturen als Streifenleiter 10, 11, 12 ausgebildet. Eines dieser Bündel von Leiterstrukturen ist die Leitstruktur 10, die aus Leitstreifen in mehreren Ebenen der Leiterplatte besteht, welche mit mehreren Durchkontaktierungen (Vias) verbunden sind. Wie erkennbar, sind diese Leiterstrukturen an der oberen Begrenzung der Leiterplatte 7 ausgebildet und dienen der Detektion einer Betätigung im angrenzenden Bereich der Handhabe 2. Unterhalb der Leiterstruktur 10 ist eine Leiterstruktur 11 ausgebildet, welche von der Steuerelektronik als Shield-Elektrode für die Detektionselektrode 10 betrieben wird. Die Leiterstrukturen 10, 11 und 12 sind zu Erfassungszwecken mit der Steuerelektronik 5 gekoppelt. Weiterhin ist im unteren Abschnitt die Masseelektrode 12 ausgebildet, die ebenfalls aus mehreren Leiterstrukturen in benachbarten Leiterbahnen gebildet ist. Die einzelnen Leiterstrukturen der Masseelektrode 12 in den verschiedenen Leiterplatten-Ebenen sind jedoch nicht mit Vias verbunden, sondern mit einem Massekontakt auf jeder der Leiterebenen. Dies soll verdeutlichen, dass sowohl eine Durchkontaktierung mit Vias als auch eine einzelne Kontaktierung von zentralem Punkt aus grundsätzlich möglich ist, auch bei den Sensorelektroden.

In den Figuren 1A bis 1C ist eine Bereich A gezeigt, welcher den Detektionsbereich der Sensorelektrode 10 stilisiert darstellen soll. Aufgrund der Anordnung und Ausbildung der Sensorelektrode 10 durch die benachbarten Schichten in den Leiterplattenebenen ist die Detektionsreichweite und Detektionsgenauigkeit geringer als bei der flächigen Elektrode 6. Es soll jedoch auch durch diese Elektrode nur eine Annäherung in unmittelbarer Nähe der Elektrode detektiert werden, insbesondere ein Auflegen eines Fingers auf den Bereich A der Handhabe. Durch eine solche Betätigung soll beispielsweis die Schließfunktion nach Verlassen des Fahrzeuges ausgelöst werden. Durch die Anordnung der Shield-Elektrode 11 und der Masse 12 ist ausgeschlossen, dass eine Detektion auch in anderen Bereichen der Handhabe stattfindet.

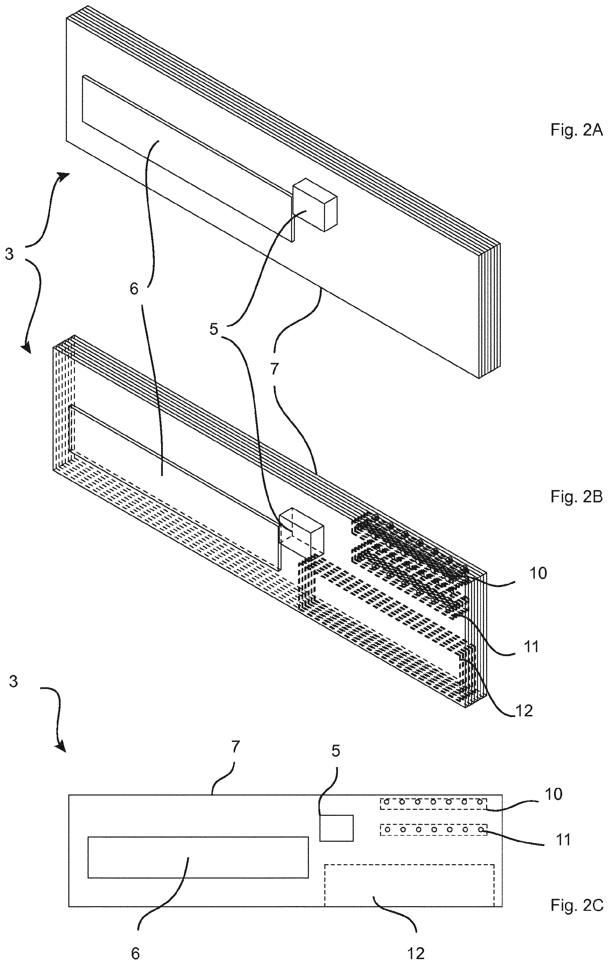

Die Figuren 2A, 2B und 2C verdeutlichen den Aufbau der Sensoranordnung 3 weiter. In Figur 2B sind die Leiterplattenebenen transparent dargestellt, ebenso wie in Figur 2C, um die Anordnung und Funktion der Strukturen 10, 11 und 12 deutlicher darzustellen. Die Leitstrukturen der Elektroden 10, 11 und 12 sind in einfacher Weise und bei der Herstellung der Leitplatten gemäß üblichem Verfahren als Leitstrukturen aufgebracht. Die Durchkontaktierungen in den Strukturen 10 und 11 sind ebenfalls im Rahmen der herkömmlichen Leiterplattenproduktion ohne wesentliche Änderungen anzuordnen. Es ist erkennbar, dass eine Dimensionierung der Elektroden zur Anpassung des Erfassungsbereiches problemlos möglich ist, beispielsweise kann die Sensorelektrode 10 an einem anderen Begrenzungsrand, zum Beispiel rechts oder links der Platine angeordnet werden und die Schirmelektrode 11 kann größer oder kleiner ausgebildet sein, oder auch als umgreifende Elektrode zu der Elektrode 10 oder als Elektrodenbogen. Wesentlich ist, dass gemäß der Erfindung zusätzlich zu der Elektrode 6, welche auf einer Elektrodenfläche angeordnet ist, eine dazu senkrechte wirkende Elektrode 10 gebildet ist, indem die mehreren Schichten der Leiterplatte zur Bildung einer Leiterstruktur zusammenwirken.

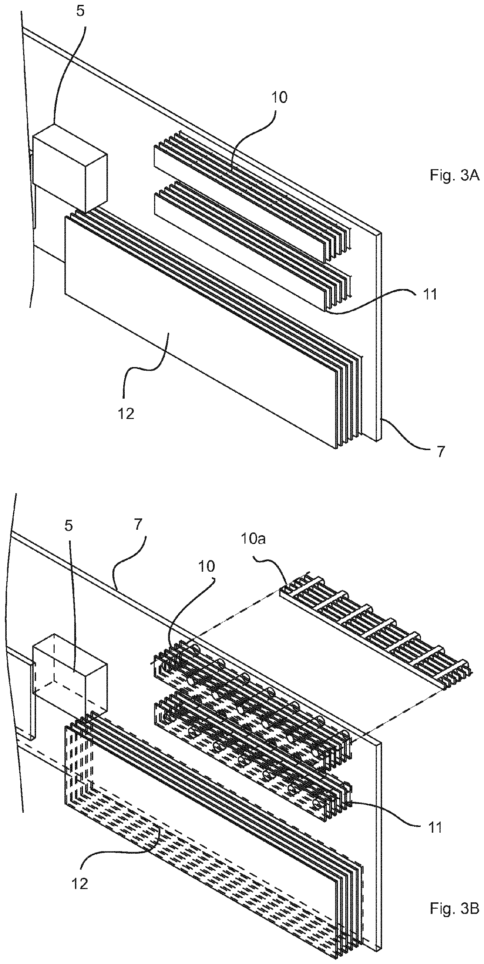

In Figur 3A sind zur weiteren Verdeutlichung bis auf die hintere Leiterplattenebene die Plattenebenen selbst entfernt, so dass nur noch die Leitstrukturen stehen bleiben. Hier wird deutlich, dass sich eine Art gefächerte Elektrodenstruktur oder auch Gitterstruktur in der Richtung der Schmalseite der Leiterplattenanordnung bildet. Figur 3B zeigt diese Darstellung nochmals in der teildurchlässigen Sicht, in der auch die Durchkontaktierungen der Elektroden 10 und 11 sichtbar werden. Ein Schnitt durch den oberen Elektrodenbereich der Elektrode 10 macht deutlich, dass sich ein Elektrodengitter bildet, welches eine Detektionsrichtung in Sichtrichtung der Schmalseite der Platine ausbildet. Eine Verdeutlichung ist mit dem ausgeschnittenen Elektrodenteil 10a dargestellt. Es ist zwar durchaus so, dass sich auch die Elektrodenflächen zur Seite (also zu den Flachseiten der Elektrodenstrukturen) hin als Sensorelektrode verhalten, nebeneinanderliegende Elektroden schirmen sich jedoch dabei im Wesentlichen aufgrund der Potentialgleichheit gegenseitig ab und es resultiert, auch durch die Verwendung der Shield-Elektrode 11, eine Gesamtwirkung mit Detektionsbereich zur Schmalseite der Platine.

Es ist grundsätzlich denkbar, auf den äußersten Leiterplattenebenen, also umgebend zu der Leiterplatte 10 die Shield-Elektrode weiterzuführen, um eine Wirkung der Sensorelektrode 10 in Richtung der Flachseiten der Leiterplatte weiter zu reduzieren.

Auf die beschriebene Weise wird eine Sensorelektrode mit einer Detektionsrichtung hin zur Schmalseite einer Leiterplatte ausgebildet, und zwar durch einfache und herkömmliche Herstellungsschritte, wie sie bereits jetzt bei der Leiterplattenherstellung verwendet werden. Die Verwendung benachbarter Plattenebenen zur Bildung einer Gitterelektrode erhöht den Produktionsaufwand kaum und stellt eine verlässliche und sichere sowie kostengünstige Möglichkeit dar, auf zusätzliche gewinkelte Elektrodenbleche oder sonstige Elektrodenanordnungen zu verzichten.

## Patentansprüche

1. Kraftfahrzeug-Türgriff (1, 2) mit einer ersten Sensorelektrode (10) eines ersten kapazitiven Sensors zum Auslösen eines Betätigungsvorgangs bei Erfassung einer Annäherung eines Bedienerkörperteils an die erste Sensorelektrode,
einer in der Griff-Handhabe (2) angeordneten Leiterplatte (7), welche elektrische Bauteile auf einer Leitplattenfläche aufnimmt und welche die Sensorelektrode (10) trägt sowie eine mit der ersten Sensorelektrode (10) gekoppelte Auswerteschaltung (5), welche zur Erfassung der Kapazität der ersten Sensorelektrode mit der ersten Sensorelektrode gekoppelt ist,
wobei die Leiterplatte (7) als mehrlagige Leiterplatte ausgebildet ist,
**dadurch gekennzeichnet,**
**dass** die erste Sensorelektrode (10) durch eine Mehrzahl von Leiterstrukturen gebildet ist, die in benachbarten Leiterplattenebenen ausgebildet sind, wobei die Leiterstrukturen mit Durchkontaktierungen der Leiterplattenebenen derart elektrisch gekoppelt sind, dass die Durchkontaktierungen und die Leiterstrukturen in den Leiterplattenebenen die erste Sensorelektrode (10) als Leiternetz ausbilden, dessen Netzebene quer zu den Leiterplattenebenen und der Leiterplattenfläche und innerhalb der Leiterplatte (7) liegt.

2. Kraftfahrzeug-Türgriff nach Anspruch 1, wobei in der Griff-Handhabe wenigstens eine weitere Sensorelektrode (6) ausgebildet ist, welche als flächige Elektrode ausgebildet ist und parallel zu den Leiterplattenebenen ausgerichtet ist.

3. Kraftfahrzeug-Türgriff nach Anspruch 1 oder 2, wobei zu der ersten Sensorelektrode (10) eine Schirm-Elektrode (11) ausgebildet ist, um den Erfassungsbereich der ersten Sensorelektrode (10) zu definieren, wobei die Schirm-Elektrode (11) ebenfalls aus einer Mehrzahl von Leiterstrukturen gebildet ist, die in benachbarten Leiterplattenebenen ausgebildet sind.

4. Kraftfahrzeug-Türgriff nach Anspruche 3, wobei die Schirm-Elektrode (11) ebenfalls Durchkontaktierungen aufweist.

5. Kraftfahrzeug-Türgriff nach Anspruch 3 oder 4, wobei die Schirmelektrode (11) mit ihren Leiterstrukturen die erste Sensorelektrode (10) in wenigstens einer der Leiterplattenebenen teilweise umgreift, so dass die Schirmelektrode (11) die Sensorelektrode zu mehreren Seiten abschirmt.

6. Kraftfahrzeug-Türgriff nach Anspruch 5, wobei die Schirmelektrode die Sensorelektrode (10) zu drei Seiten umgreift, so dass die Sensorelektrode lediglich in Richtung des Detektionsbereiches freiliegt.

7. Kraftfahrzeug-Türgriff nach Anspruch 5 oder 6, wobei die Schirmelektrode in äußeren Lagen der Leiterplatte mit derartigen Leiterstrukturen gebildet ist, dass die äußeren Lagen der Schirmelektrode die Sensorelektrode in den mittleren Leiterplattenlagen umgreifen, so dass die Sensorelektrode durch die Schirmelektrode wannenartig eingefasst ist.

8. Kraftfahrzeug-Türgriff nach einem der vorangehenden Ansprüche, wobei die Sensorelektrode unmittelbar an einer seitlichen Begrenzung der Leiterplatte ausgebildet ist.

9. Kraftfahrzeug-Türgriff nach einem der vorangehenden Ansprüche, wobei mehrere Sensorelektroden der genannten Art durch Leiterstrukturen in verschiedenen Ebenen der Leiterplatte in verschiedenen Leiterplattenbereichen ausgebildet sind.

10. Kraftfahrzeug-Türgriff nach einem der vorangehenden Ansprüche, wobei wenigstens eine Masse-Elektrode durch eine Mehrzahl von Leiterstrukturen gebildet ist, die in benachbarten Leiterplattenebenen ausgebildet sind.

## Claims

1. A motor vehicle door handle (1, 2) having a first sensor electrode (10) of a first capacitive sensor for triggering an actuation process when detecting an approach of an operator body part to the first sensor electrode,
a printed circuit board (7) arranged in the grip handle (2) which accommodates electrical components on a printed circuit board surface and which carries the sensor electrode (10) as well as an evaluation circuit (5) coupled to a first sensor electrode (10) which is coupled to the first sensor electrode to record the capacitance of the first sensor electrode,
wherein the printed circuit board (7) is configured as a multilayer printed circuit board,
**characterized in**
**that** the first sensor electrode (10) is formed by a plurality of conductor structures which are formed in neighbouring printed circuit board planes, wherein the conductor structures are electrically coupled with vias of the printed circuit board planes, that the vias and the conductor structures in the printed circuit board planes form the first sensor electrode (10) as a conductor network, whose network plane lies transversely to the printed circuit board plane and the printed circuit board surface and inside the printed circuit board (7).

2. The motor vehicle door handle according to claim 1, wherein at least one further sensor electrode (6) is formed in the grip handle, which is configured as a flat electrode and is aligned parallel to the printed circuit board planes.

3. The motor vehicle door handle according to claim 1 or 2, wherein a shield electrode (11) is formed to the first sensor electrode (10) in order to define the coverage of the first sensor electrode (10), wherein the shield electrode (11) is also formed from a plurality of conductor structures which are formed in neighbouring printed circuit board planes.

4. The motor vehicle door handle according to claim 3, wherein the shield electrode (11) also has vias.

5. The motor vehicle door handle according to claim 3 or 4, wherein the shield electrode (11) with its conductor structures partially surrounds the first sensor electrode (10) in at least one of the printed circuit board planes so that the shield electrode (11) shields the sensor electrode on several sides.

6. The motor vehicle door handle according to claim 5, wherein the shield electrode surrounds the sensor electrode (10) on three sides so that the sensor electrode is only exposed in the direction of the detection zone.

7. The motor vehicle door handle according to claim 5 or 6, wherein the shield electrode is formed in outer layers of the printed circuit board with such conductor structures that the outer layers of the shield electrode surround the sensor electrode in the central printed circuit board layers so that the sensor electrode is bordered in a trough-like manner by the shield electrode.

8. The motor vehicle door handle according to one of the preceding claims, wherein the sensor electrode is formed directly on a lateral boundary of the printed circuit board.

9. The motor vehicle door handle according to one of the preceding claims, wherein a plurality of sensor electrodes of the said type are formed by conductor structures in different planes of the printed circuit board in different printed circuit board zones.

10. The motor vehicle door handle according to one of the preceding claims, wherein at least one ground electrode is formed by a plurality of conductor structures which are formed in adjacent printed circuit board planes.

## Revendications

1. Poignée de portière de véhicule automobile (1,2) avec une électrode de capteur (10) d'un premier capteur capacitif pour déclencher une opération d'actionnement lors de la saisie d'une approche de la première électrode de capteur d'une partie corporelle d'utilisateur,
une carte de circuits imprimés (7) disposée dans la manette de poignée (2), laquelle loge les composants électriques sur une surface de carte de circuits imprimés et laquelle porte l'électrode de capteur (10) ainsi qu'un circuit d'exploitation (5) couplé à la première électrode de capteur (10), lequel est couplé à la première électrode de capteur pour saisir la capacité de la première électrode de capteur,
la carte de circuits imprimés (7) étant constituée comme carte de circuits imprimés multicouches,
**caractérisée en ce**
**que** la première électrode de capteur (10) est formée par une pluralité de structures conductrices, qui sont constitués dans des plans de carte de circuits imprimés voisins, les structures conductrices étant couplées électriquement aux interconnexions des plans de carte de circuits imprimés de telle manière que les interconnexions et les structures conductrices constituent dans les plans de carte de circuits imprimés la première électrode de capteur (10) en tant que réseau de conducteurs, dont le plan de réseau se situe transversalement aux plans de carte de circuits imprimés et à la surface de carte de circuits imprimés et à l'intérieur de la carte de circuits imprimés (7).

2. Poignée de portière de véhicule automobile selon la revendication 1, au moins une autre électrode de capteur (6) étant constituée dans la manette de poignée, laquelle est constituée comme électrode plate et est orientée parallèlement aux plans de carte de circuits imprimés.

3. Poignée de portière de véhicule automobile selon la revendication 1 ou 2, une grille de protection (11) étant constituée à la première électrode de capteur (10) pour définir la zone de saisie de la première électrode de capteur (10), la grille de protection (11) étant formée de la même manière à partir d'une pluralité de structures conductrices, qui sont constituées dans des plans de cartes de circuits imprimés voisins.

4. Poignée de portière de véhicule automobile selon la revendication 3, la grille de protection (11) comportant également des interconnexions.

5. Poignée de portière de véhicule automobile selon la revendication 3 ou 4, la grille de protection (11) entourant en partie la première électrode de capteur (10) avec ses structures conductrices dans au moins un des plans de carte de circuits imprimés de telle sorte que la grille de protection (11) protège l'électrode de capteur pour plusieurs côtés.

6. Poignée de portière de véhicule automobile selon la revendication 5, la grille de protection entourant l'électrode de capteur (10) sur trois côtés de telle sorte que l'électrode de capteur n'est dégagée qu'en direction de la zone de détection.

7. Poignée de portière de véhicule automobile selon la revendication 5 ou 6, la grille de protection étant formée dans les couches extérieures de la carte de circuits imprimés avec un type de structures conductrices de telle sorte que les couches extérieures de la grille de protection entourent l'électrode de capteur dans les couches centrales de carte de circuits imprimés de telle manière que l'électrode de capteur est englobée en forme de berceau par la grille de protection.

8. Poignée de portière de véhicule automobile selon l'une quelconque des revendications précédentes, l'électrode de capteur étant constituée directement sur une délimitation latérale de la carte de circuits imprimés.

9. Poignée de portière de véhicule automobile selon l'une quelconque des revendications précédentes, plusieurs électrodes de capteur du type cité étant constituées par des structures conductrices dans différents plans de la carte de circuits imprimés dans différentes zones de carte de circuits imprimés.

10. Poignée de portière de véhicule automobile selon l'une quelconque des revendications précédentes, au moins une électrode de masse est formée par une pluralité de structures conductrices, qui sont constituées dans les plans de carte de circuits imprimés voisins.
